(19) **Europäisches Patentamt / European Patent Office / Office européen des brevets**

(11) **EP 2 422 215 B1**

(12) **FASCICULE DE BREVET EUROPEEN**

(45) Date de publication et mention
de la délivrance du brevet:
**26.02.2014 Bulletin 2014/09**

(21) Numéro de dépôt: **10714024.6**

(22) Date de dépôt: **22.04.2010**

(51) Int Cl.:
*G01S 7/41* (2006.01)  *G01R 29/08* (2006.01)

(86) Numéro de dépôt international:
**PCT/EP2010/055342**

(87) Numéro de publication internationale:
**WO 2010/122101 (28.10.2010 Gazette 2010/43)**

(54) **MÉTHODE DE CARACTÉRISATION ÉLECTROMAGNÉTIQUE D'UNE CIBLE**

VERFAHREN ZUM ELEKTROMAGNETISCHEN CHARAKTERISIEREN EINES ZIELS

METHOD FOR ELECTROMAGNETICALLY CHARACTERIZING A TARGET

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **24.04.2009 FR 0952712**

(43) Date de publication de la demande:
**29.02.2012 Bulletin 2012/09**

(73) Titulaire: **Commissariat à l'Énergie Atomique et aux Énergies Alternatives
75015 Paris (FR)**

(72) Inventeurs:
• **COGNAULT, Aurore**
 **F-33160 Saint-medard-en-jalles (FR)**
• **MORVAN, Sylvain**
 **F-33160 Saint-medard-en-jalles (FR)**
• **VACUS, Olivier**
 **F-33610 Cestas (FR)**

(74) Mandataire: **Ilgart, Jean-Christophe et al
BREVALEX
95, rue d'Amsterdam
75378 Paris Cedex 8 (FR)**

(56) Documents cités:
**FR-A1- 2 914 750    US-B1- 6 756 935**

• **DOREN W HESS ED - WEBER J ET AL: "Introduction to RCS measurements" ANTENNAS AND PROPAGATION CONFERENCE, 2008. LAPC 2008. LOUGHBOROUGH, IEEE, PISCATAWAY, NJ, USA, 17 mars 2008 (2008-03-17), pages 37-44, XP031249948 ISBN: 978-1-4244-1893-0**
• **LARSSON C ET AL: "Measuring the extinction cross section" ANTENNAS AND PROPAGATION, 2009. EUCAP 2009. 3RD EUROPEAN CONFERENCE ON, IEEE, PISCATAWAY, NJ, USA, 23 mars 2009 (2009-03-23), pages 3633-3636, XP031470552 ISBN: 978-1-4244-4753-4**

**Description**

**DOMAINE TECHNIQUE**

La présente invention concerne le domaine de la caractérisation électromagnétique d'une cible dans le domaine des basses fréquences. Elle trouve notamment application dans le domaine du contrôle ou de la maintenance.

**ÉTAT DE LA TECHNIQUE ANTÉRIEURE**

On caractérise classiquement une cible par sa surface équivalente radar ou SER. La SER d'une cible radar est définie à partir du bilan de puissance de l'onde émise en direction de la cible et de la puissance de l'onde reçue par le radar. En champ lointain et en approximant les ondes à des ondes planes, l'équation radar s'écrit en effet.

$$P_r = P_e G_e \frac{1}{4\pi d^2} \sigma \frac{1}{4\pi d^2} G_r \frac{\lambda^2}{4\pi} \tag{1}$$

où $P_e$ et $P_r$ sont respectivement les puissances des ondes émise et reçue par le radar, $G_e$ et $G_r$ les gains d'antenne à l'émission et à la réception, $d$ la distance entre le radar et la cible, $\lambda$ la longueur d'onde utilisée par le radar. Le coefficient $\sigma$ est homogène à une surface et ne dépend que de la cible considérée, c'est la SER de la cible.

Dans l'expression (1), on a supposé que le radar servant à illuminer la cible était le même que celui servant à la réception de l'onde diffractée, on parle alors de SER monostatique. En règle générale, la SER monostatique dépend de la direction de l'onde incidente, de la fréquence $f$ du radar et des polarisations respectives $\pi_e$ et $\pi_r$ avec lesquelles l'onde incidente est émise et l'onde reçue est analysée. On la note $SER(f, \varphi, \theta, \pi_e, \pi_r)$, où $(\varphi, \theta)$ sont les angles de gisement et de roulis du radar dans un référentiel lié à la cible. Chacune des polarisations $\pi_e$ et $\pi_r$ peut être horizontale ou verticale, c'est-à-dire $\pi_e = H$ ou $V$ ; $\pi_r = H$ ou $V$.

La mesure d'une SER se fait dans un local anéchoïque, c'est-à-dire dans un local dont les parois sont tapissées d'absorbants, de manière à éviter les échos parasites. La cible est disposée à l'aide d'un positionneur faiblement échogène, généralement sur une colonne verticale en polystyrène orientable autour de son axe propre. La mesure est réalisée, soit au moyen d'une seule antenne, soit au moyen de deux antennes distinctes légèrement décalées angulairement l'une par rapport à l'autre. Selon le cas on obtient les valeurs de SER monostatique ou de SER quasi-monostatique, pour un angle ou une pluralité d'angles de gisement. L'antenne d'émission doit être choisie de manière à générer une onde aussi plane que possible.

Le document FR 2 914 750 expose un exemple d'estimation de la SER d'un objet, à partir d'un modèle de diffraction de cet objet. Ce modèle de diffraction correspond à une matrice de paramètres correspondants à des rapports d'amplitudes complexes d'onde diffractée et d'onde incidente, pour différents couples de directions et de polarisations respectives de l'onde incidente et de l'onde diffractée.

La caractérisation d'un objet par sa SER présente un certain nombre d'inconvénients.

Tout d'abord, il est très coûteux de construire un local anéchoïque pour des objets de tailles importantes. Ce problème est encore aggravé en basse fréquence, c'est-à-dire pour des longueurs d'onde de l'ordre de la taille de l'objet, c'est-à-dire classiquement de l'ordre du mètre à quelques dizaines de mètres, où l'efficacité des absorbants est moindre. Les mesures effectuées sont généralement affectées par des bruits de sources diverses (échos parasites, bruit d'instrumentation etc.)

En régime basse fréquence encore, l'antenne d'illumination doit être de grande taille de manière à pouvoir générer des ondes approximativement planes.

Enfin, on n'effectue généralement que quelques mesures de valeurs de SER, typiquement selon quelques angles de gisement dans un plan équatorial de sorte que l'on ne dispose que d'une caractérisation directionnelle assez sommaire de la cible.

La mesure de SER suppose par conséquent de mettre en oeuvre des moyens matériels importants et ne permet pas, tout particulièrement en basse fréquence, de caractériser la diffraction électromagnétique par un objet de manière satisfaisante.

En outre, dans le domaine du contrôle ou de la maintenance, il suffit souvent de vérifier la conformité des caractéristiques d'un objet à un gabarit prédéterminé ou encore d'évaluer l'évolution de ces caractéristiques au cours du temps. Le recours à une caractérisation par SER peut alors s'avérer inutilement complexe par rapport au but recherché.

L'objectif de la présente invention est de proposer une méthode de caractérisation électromagnétique d'un objet qui soit simple à mettre en oeuvre, y compris dans le domaine des basses fréquences, et qui permette cependant de vérifier que l'objet présente des caractéristiques de diffraction électromagnétique conformes à un gabarit ou des valeurs de consigne, selon des directions pertinentes.

## EXPOSÉ DE L'INVENTION

L'invention est définie par une méthode de caractérisation électromagnétique d'un objet à une fréquence donnée, selon laquelle on place ledit objet dans une enceinte dont au moins certaines parois sont faiblement absorbantes à ladite fréquence, une des parois de l'enceinte étant équipée d'un réseau d'antennes, chaque antenne pouvant émettre une et recevoir des ondes électromagnétiques selon une première polarisation et une seconde polarisation orthogonale à la première, ladite méthode comprenant les étapes suivantes :

- en absence dudit objet dans l'enceinte, on mesure un premier ensemble de valeurs complexes, chaque valeur complexe étant déterminée comme le rapport entre l'amplitude d'une onde reçue et une onde émise, l'onde émise étant obtenue en pondérant des signaux émis par les différentes antennes à l'aide de premiers coefficients complexes de pondération, et l'onde reçue étant obtenue en pondérant des signaux reçus par les mêmes antennes à l'aide de seconds coefficients complexes de pondération ;
- en présence dudit objet dans l'enceinte, on mesure un second ensemble de valeurs complexes, chaque valeur complexe étant déterminée comme le rapport entre l'amplitude d'une onde reçue et une onde émise, l'onde émise étant obtenue en pondérant des signaux émis par les différentes antennes à l'aide desdits premiers coefficients complexes de pondération, et l'onde reçue étant obtenue en pondérant des signaux reçus par les mêmes antennes à l'aide desdits seconds coefficients complexes de pondération ;
- on soustrait les valeurs complexes du premier ensemble aux valeurs complexes correspondantes du second ensemble pour obtenir une liste de valeurs complexes corrigées et on fournit au moins une sous-liste de la liste de valeurs complexes corrigées comme caractéristique électromagnétique dudit objet.

Pour chaque valeur complexe du premier ou du second ensemble, les premiers coefficients de pondération sont les éléments d'un vecteur propre d'une matrice de paramètres S corrigés et les seconds coefficients de pondération sont obtenus par conjugaison complexe des premiers coefficients de pondération, la matrice de paramètres S corrigés étant obtenue par différence entre la matrice de paramètres S d'un premier système et celle d'un second système, le premier système étant constitué de l'enceinte et dudit réseau d'antennes, le second système étant constitué de l'enceinte, de l'objet et dudit réseau d'antennes, les paramètres S du premier et du second systèmes étant mesurés pour chaque antenne d'émission ainsi que chaque polarisation d'émission et chaque antenne de réception ainsi que chaque polarisation de réception.

Les vecteurs propres peuvent être préalablement déterminés à partir d'une matrice des paramètres S corrigés, ladite matrice étant obtenue au moyen d'une simulation.

Alternativement, lesdits vecteurs propres peuvent être préalablement déterminés à partir d'une matrice des paramètres S corrigés, ladite matrice étant obtenue en utilisant une maquette dudit objet.

L'enceinte est typiquement de forme parallépipédique et ouverte à l'une de ses extrémités, le réseau d'antennes étant disposé sur la face du parallépipède opposée à l'extrémité ouverte. Les parois de l'enceinte peuvent être métalliques.

Le réseau d'antennes est avantageusement bidimensionnel.

Enfin, les étapes de la méthode de caractérisation électromagnétique précitée peuvent être répétées pour une pluralité de fréquences appartenant à une bande de fréquence prédéterminée.

## BRÈVE DESCRIPTION DES DESSINS

D'autres caractéristiques et avantages de l'invention apparaîtront à la lecture d'un mode de réalisation préférentiel de l'invention décrit à l'aide des figures ci-jointes :

La Fig. 1 représente de manière schématique un exemple de dispositif expérimental permettant de mettre en oeuvre la méthode de caractérisation électromagnétique d'une cible selon un mode de réalisation de l'invention ;

La Fig. 2 représente de manière schématique un organigramme d'une première méthode de caractérisation d'une cible ;

La Fig. 3 représente de manière schématique un organigramme de la méthode de caractérisation d'une cible selon l'invention.

## EXPOSÉ DÉTAILLÉ DE MODES DE RÉALISATION PARTICULIERS

On considérera dans la suite un objet O dont on souhaite caractériser les propriétés de diffraction électromagnétique, avantageusement mais non exclusivement en basse fréquence, au sens défini plus haut. Cet objet peut en général être modélisé à l'aide d'une condition d'impédance, c'est-à-dire par une couche de matériau de permittivité électrique $\varepsilon_r$ et de perméabilité magnétique $\mu_r$ recouvrant un conducteur parfait. L'objet en question peut être inhomogène auquel cas l'épaisseur de la couche, sa permittivité électrique, sa perméabilité magnétique peuvent différer d'un point à un autre de l'objet. On rappelle que l'impédance d'une couche d'épaisseur $e$, de permittivité électrique $\varepsilon_r$ et de perméabilité magnétique $\mu_r$, est donnée par :

$$\eta = -i\sqrt{\frac{\mu_r}{\varepsilon_r}}\tan\left(ke\sqrt{\varepsilon_r\mu_r}\right) \qquad (2)$$

où $k = \dfrac{2\pi}{c}f$ est le nombre d'onde de l'onde incidente, $f$ sa fréquence et $c$ la vitesse de la lumière dans le vide. Le choix de la dépendance temporelle des ondes est conventionnellement pris en exp($-i\omega t$).

L'objet O dont on recherche à caractériser les propriétés de diffraction électromagnétique peut être de forme quelconque.

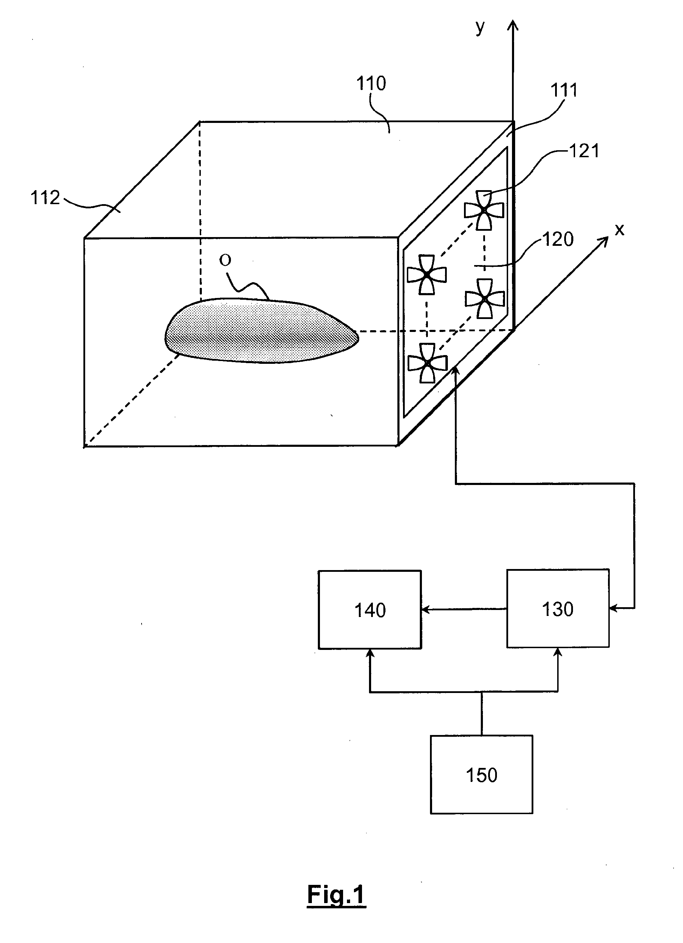

La Fig. 1 représente de manière schématique un exemple de dispositif expérimental pour mettre en oeuvre la méthode de caractérisation selon un mode de réalisation de l'invention.

Le dispositif expérimental comprend une enceinte 110, avantageusement de forme parallépipédique et ouverte à une extrémité, dans laquelle on dispose l'objet O à caractériser. L'objet O peut être placé sur un positionneur ou bien suspendu au sein de l'enceinte 110, de préférence au centre de l'enceinte.

Les parois de l'enceinte, ou certaines d'entre elles seulement, sont faiblement absorbantes à la fréquence de mesure. Par faiblement absorbantes on entend ici que ces parois ne permettent d'absorber que peu voire pas du tout les ondes électromagnétiques à la fréquence de mesure et donc qu'une majeure partie de ces ondes est réfléchie. En particulier, ces parois peuvent être métalliques et donc fortement réfléchissantes.

Une de ces parois, 111, avantageusement la face du parallépipède opposée à l'extrémité ouverte, 112, est équipée d'un réseau d'antennes, typiquement un réseau bidimensionnel 120, connecté à un dispositif d'émission/réception, 130, ce dispositif étant lui-même commandé par des moyens de commande 150. Le dispositif d'émission/réception est connecté à un analyseur de réseau 140, également piloté par les moyens de commande 150.

Les antennes 121 du réseau bidimensionnel 120 sont à diversité de polarisation et peuvent émettre et recevoir selon deux directions de polarisation orthogonales, de préférence selon les directions $x$ et $y$ définissant le plan du réseau bidimensionnel, c'est-à-dire respectivement selon une polarisation horizontale et une polarisation verticale. Les antennes 121 peuvent être par exemple de type doublet replié.

Le dispositif d'émission/réception 130 est commandé par les moyens de commande 140 de sorte qu'une ou plusieurs antenne(s) 121 peuvent émettre à la fois, en polarisation horizontale ou en polarisation verticale. Lorsque plusieurs antennes émettent simultanément, le dispositif de commande permet de commander les gains complexes (gains et déphasages) des antennes émettrices. De même, le dispositif d'émission/réception 130 est commandé de manière à ce qu'une seule antenne soit réceptrice ou certaines antennes 121 soient simultanément réceptrices, selon une polarisation horizontale ou verticale. Lorsque plusieurs antennes sont simultanément réceptrices, le dispositif de commande permet de commander les gains complexes (gains et déphasages) appliqués aux différents signaux reçus par ces antennes.

Si l'on note $N$ le nombre d'antennes, le système constitué par l'enceinte, l'objet O et les $N$ antennes peut être considéré comme un multipôle à $2N$ entrées et $2N$ sorties, où le facteur 2 traduit la diversité de polarisation. On note **S** la matrice de taille $2N\times2N$ des paramètres $S$ de ce multipôle, à savoir :

$$
\mathbf{S} = \begin{pmatrix}
S_{11}^{HH} & S_{12}^{HH} & \cdots & S_{1N}^{HH} & S_{11}^{HV} & S_{12}^{HV} & \cdots & S_{1N}^{HV} \\
S_{21}^{HH} & S_{22}^{HH} & \cdots & S_{2N}^{HH} & S_{21}^{HV} & S_{22}^{HV} & \cdots & S_{2N}^{HV} \\
\vdots & \vdots & \ddots & \vdots & \vdots & \vdots & \ddots & \vdots \\
S_{N1}^{HH} & S_{N2}^{HH} & \cdots & S_{NN}^{HH} & S_{N1}^{HV} & S_{N2}^{HV} & \cdots & S_{NN}^{HV} \\
S_{11}^{VH} & S_{12}^{VH} & \cdots & S_{1N}^{VH} & S_{11}^{VV} & S_{12}^{VV} & \cdots & S_{1N}^{VV} \\
S_{21}^{VH} & S_{22}^{VH} & \cdots & S_{2N}^{VH} & S_{21}^{VV} & S_{22}^{VV} & \cdots & S_{2N}^{VV} \\
\vdots & \vdots & \ddots & \vdots & \vdots & \vdots & \ddots & \vdots \\
S_{N1}^{VH} & S_{N2}^{VH} & \cdots & S_{NN}^{VH} & S_{N1}^{VV} & S_{N2}^{VV} & \cdots & S_{NN}^{VV}
\end{pmatrix} \qquad (3)
$$

où chaque élément $S_{ij}^{\pi_e,\pi_r}$ est la valeur complexe du paramètre $S$ pour une onde émise par l'antenne $i$ avec une polarisation $\pi_e = H$ ou $V$ et reçue par l'antenne $j$ selon une polarisation $\pi_r = H$ ou $V$ avec $i,j = 1,..,N$. Plus précisément, le paramètre $S_{ij}^{\pi_e,\pi_r}$ est le rapport de l'amplitude complexe de l'onde reçue par l'antenne $j$ selon une polarisation $\pi_r$ et de l'amplitude complexe de l'onde émise par l'antenne $i$ avec une polarisation $\pi_e$.

L'analyseur de réseau 140 permet de calculer les paramètres $S$ du multipôle, c'est-à-dire les coefficients de la matrice **S** à partir des signaux émis et reçus par le réseau d'antennes.

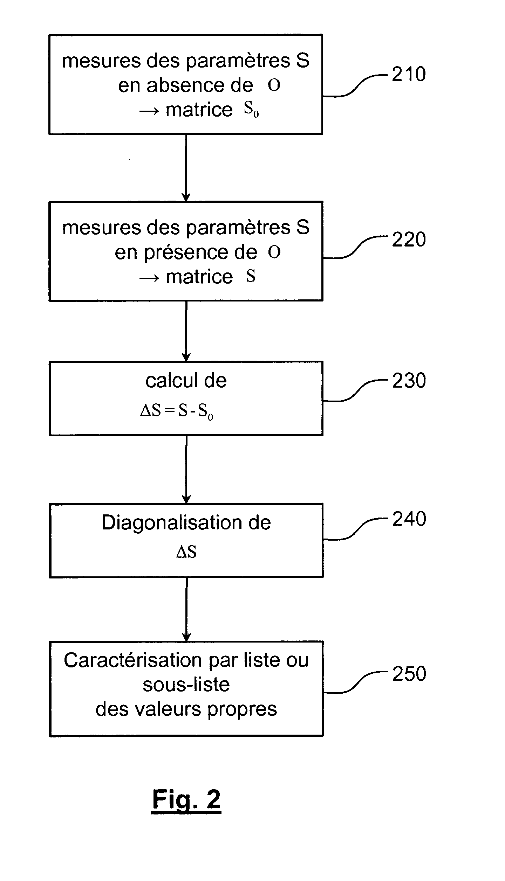

La Fig. 2 représente de manière schématique l'organigramme d'une première méthode de caractérisation.

A l'étape 210, on procède aux mesures des paramètres $S$ en absence de l'objet à caractériser. Les antennes élémentaires sont excitées tour à tour selon leur polarisation horizontale et leur polarisation verticale et les signaux reçus par les différentes antennes sont transmis séquentiellement ou parallèlement à l'analyseur de réseau.

On obtient ainsi une matrice $\mathbf{S_0}$ donnant les paramètres $S$ d'un premier système constitué par l'enceinte et le réseau d'antennes (et, le cas échéant, du positionneur lorsqu'il est présent). On notera que du fait de la symétrie de propagation, il pourra suffire de déterminer la moitié des termes non-diagonaux de la matrice puisque $S_{ij}^{\pi_e,\pi_r} = S_{ji}^{\pi_e,\pi_r}$ avec les notations ci-dessus.

A l'étape 220, on procède aux mesures des paramètres $S$ en présence de l'objet placé dans l'enceinte. Pour ce faire, on excite séquentiellement les antennes élémentaires selon leur polarisation horizontale et leur polarisation verticale et les signaux reçus par les différentes antennes sont transmis séquentiellement ou parallèlement à l'analyseur de réseau, comme précédemment.

On obtient ainsi une matrice **S** donnant les paramètres $S$ d'un second système constitué par l'enceinte, l'objet $O$ à caractériser et le réseau d'antennes. Pour la même raison que précédemment, seule la moitié des termes non-diagonaux de la matrice pourra être déterminée.

On notera que les étapes 210 et 220 pourront être interverties, l'ordre de la mesure étant indifférent.

A l'étape 230, on soustrait de la matrice **S**, la matrice $\mathbf{S_0}$. La différence $\Delta\mathbf{S}=\mathbf{S}-\mathbf{S_0}$ permet de s'affranchir sensiblement de la réponse de diffraction de l'enceinte (et du positionneur lorsqu'il est présent).

On peut montrer que, si la surface de l'objet est parfaitement conductrice, la matrice $\Delta\mathbf{S}$, notée alors $\Delta\mathbf{S}^\infty$, est diagonalisable, à tout le moins en première approximation. Cette propriété est à rapprocher du fait que l'opérateur de diffraction est lui-même diagonalisable dans une base de champs lointains caractéristiques. Par opérateur de diffraction on entend la fonction définie sur l'espace les fonctions de carré intégrable $\mathcal{L}^2(\mathbf{R}^3)$ qui au champ lointain d'une onde entrante associe le champ lointain de l'onde sortante correspondante. Chaque champ lointain caractéristique est dû au rayonnement d'une distribution de courant à la surface de l'objet, dénommée courant caractéristique. On trouvera une théorie des courants caractéristiques dans l'article de R.F. Harrington et J.R. Mautz intitulé « Theory of caracteristic modes for conducting bodies » publié dans IEEE Trans. on Antennas and Propagation, Vol. AP-19, No. 5, 1971. Dans le cas présent, cette propriété n'est vérifiée qu'en première approximation puisque les ondes incidentes sur l'objet et les ondes diffractées vers le réseau d'antennes sont en fait des ondes sphériques, et que la propagation n'a pas lieu dans un espace libre mais dans un espace confiné par l'enceinte.

On a également pu montrer expérimentalement que pour tout objet réel modélisé par une condition d'impédance telle que (2), c'est-à-dire par l'objet parfaitement conducteur précité, revêtu d'une couche d'épaisseur $e$ homogène et d'impédance η, la matrice ΔS obtenue par la mesure commutait avec la matrice ΔS$^\infty$. Qui plus est, on a constaté expérimentalement que cette propriété de commutation restait valable pour un objet présentant des impédances distinctes.

Ainsi, en première approximation, les matrices ΔS relatives à des objets différant seulement par leurs conditions d'impédance sont diagonalisables dans une même base de vecteurs propres et cette base ne dépend *a priori* que de la forme de l'objet **O** à caractériser.

A l'étape 240 on diagonalise la matrice ΔS obtenue à l'étape 230.

La matrice ΔS peut alors s'écrire comme :

$$\Delta \mathbf{S} = \mathbf{W}\mathbf{D}\mathbf{W}^{-1} \qquad (4)$$

où **D** = **diag**($\lambda_1,..,\lambda_{2N}$) est la matrice diagonale ayant pour éléments les valeurs propres $\lambda_1,..,\lambda_{2N}$ de ΔS et où **W** est la matrice de changement de base.

De nombreuses techniques de diagonalisation peuvent être envisagées, notamment celles permettant d'obtenir directement les valeurs propres, par exemple la méthode du pivot de Gauss.

Alternativement, si l'on connaît les vecteurs propres **V$_\mathbf{p}$**, $p$ =1,...,2N de la matrice ΔS, les valeurs propres correspondantes peuvent être déduites par projection :

$$\lambda_p = \mathbf{V}_\mathbf{p}^H \Delta \mathbf{S} \mathbf{V}_\mathbf{p} \qquad (5)$$

où $\mathbf{V}_\mathbf{p}^H$ est le transposé conjugué du vecteur **V$_\mathbf{p}$**. En fait, l'expression (5) donne les valeurs propres $\lambda_p$ lorsque les vecteurs propres sont unitaires, c'est-à-dire si $\mathbf{V}_\mathbf{p}^H \mathbf{V}_\mathbf{p} = 1$. On comprendra toutefois que l'expression $\mathbf{V}_\mathbf{p}^H \Delta \mathbf{S} \mathbf{V}_\mathbf{p}$ donne la valeur propre $\lambda_p$ à la norme près du vecteur **V$_\mathbf{p}$** : les valeurs $p$=1,...,2N représentent dans tous les cas une signature électromagnétique de l'objet dans la mesure où les mêmes vecteurs propres sont utilisés pour comparer les caractéristiques d'un objet avec celles d'un objet de consigne ou encore pour comparer les caractéristiques d'un objet à deux instants différents.

Les vecteurs propres peuvent être déterminés par multiples méthodes, connues en soi. Par exemple, ces derniers peuvent être obtenus une fois pour toutes au moyen d'une simulation de diffraction sur l'objet supposé parfaitement conducteur ou bien à partir de la matrice ΔS mesurée pour une maquette de l'objet, ou bien encore à partir de la matrice ΔS mesurée pour un objet ayant une SER de consigne.

La liste ordonnée des valeurs propres $\lambda_p$, $p$=1,...,2N fournie en 250 caractérise de manière univoque la distribution d'impédance sur l'objet et par conséquent constitue une signature électromagnétique de cet objet à la fréquence de mesure, au même titre que la SER. On pourra également extraire une sous-liste de cette liste pour caractériser l'objet. Par exemple, il suffira d'extraire de la liste les valeurs propres les plus significatives, c'est-à-dire celles ayant les modules les plus élevés. Cette sous-liste peut se réduire à la valeur propre la plus significative de la liste.

Selon une variante, cette signature électromagnétique est mesurée à une pluralité de fréquences, par exemple à des intervalles réguliers dans une bande de fréquence d'intérêt.

La signature électromagnétique peut être comparée à une signature de consigne pour vérifier si l'objet possède bien les caractéristiques de diffraction requises. Elle peut également être mesurée au cours de la durée de vie de l'objet pour examiner si ses caractéristiques de diffraction évoluent au cours du temps (par exemple décollement ou dégradation d'un revêtement diélectrique).

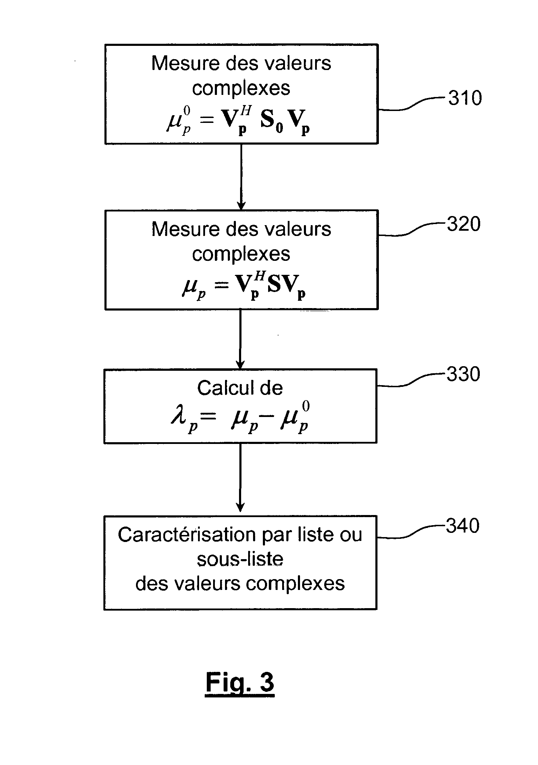

La Fig. 3 représente de manière schématique l'organigramme de la méthode de caractérisation selon l'invention.

La méthode de caractérisation selon l'invention suppose que l'on ait préalablement obtenu les vecteurs propres **V$_\mathbf{p}$**, $p$=1,...,2N, relatifs à l'objet à caractériser.

Dans une première étape, 310, on détermine les valeurs complexes :

$$\mu_p^0 = \mathbf{V}_\mathbf{p}^H \mathbf{S}_0 \mathbf{V}_\mathbf{p} \qquad (6)$$

Pour ce faire, en absence de l'objet à caractériser dans l'enceinte, on effectue pour chaque $p=1,...,2N$, une pondération à l'émission les $2N$ signaux à émettre par les éléments complexes du vecteur $\mathbf{V_p}$ et l'on applique en réception une pondération des $2N$ signaux reçus par les éléments complexes du vecteur $\mathbf{V_p^H}$. Cette pondération revient à effectuer une opération de formation de voie tant à l'émission qu'à la réception et ce à l'aide d'une pluralité de jeux de coefficients complexes, chaque jeu correspondant à un vecteur propre $\mathbf{V_p}$.

On comprendra que cette pondération à l'émission et à la réception permet de réaliser directement une projection de la mesure sur chacun des vecteurs propres.

On obtient ainsi les valeurs $\mu_p^0$, $p=1,...,2N$.

Dans une seconde étape, 320, on mesure les valeurs complexes :

$$\mu_p = \mathbf{V_p^H S V_p} \qquad (7)$$

de la même manière qu'à la première étape mais cette fois-ci en ayant préalablement placé l'objet à caractériser dans l'enceinte.

Les valeurs complexes de pondération à l'émission et à la réception sont les mêmes que précédemment et pourront par conséquent avoir été stockées en mémoire par les moyens de commande.

On obtient ainsi les valeurs $\mu_p$, $p=1,...,2N$.

Dans une troisième étape, 330, on détermine les valeurs $\lambda_p$, $p=1,...,2N$, au moyen de :

$$\lambda_p = \mu_p - \mu_p^0 \qquad (8)$$

et par conséquent la signature électromagnétique précitée. Comme précédemment, la signature électromagnétique fournie en 340, peut consister en une sous-liste de la liste de ces valeurs complexes.

On comprendra que l'avantage de la méthode de caractérisation selon l'invention par rapport à la première méthode est de réduire le nombre de mesures effectuées dans les étapes 210 et ($2N$ au lieu de $4N^2$ par étape si l'on ne tient pas compte des relations de symétrie de la matrice $\mathbf{S}$) en effectuant directement une projection modale.

Dans tous les cas, la signature électromagnétique constituée par les valeurs propres peut servir à caractériser les propriétés de diffraction électromagnétique par l'objet et ce, pour une ou plusieurs fréquences.

**Revendications**

1. Méthode de caractérisation électromagnétique d'un objet (O) à une fréquence donnée, au cours de laquelle on place ledit objet (O) dans une enceinte (110) dont au moins certaines parois sont faiblement absorbantes à ladite fréquence, l'une des parois (111) de l'enceinte étant équipée d'un réseau d'antennes (120), chaque antenne (121) pouvant émettre une et recevoir des ondes électromagnétiques selon une première polarisation (H ; V) et une seconde polarisation (V ; H) orthogonale à la première, ladite méthode comprenant en outre les étapes suivantes :

- en absence dudit objet dans l'enceinte, on mesure (310) un premier ensemble de valeurs complexes ($\mu_p^0$, $p=1,...,2N$), chaque valeur complexe étant déterminée comme le rapport entre l'amplitude d'une onde reçue et une onde émise, l'onde émise étant obtenue en pondérant des signaux émis par les différentes antennes (121) à l'aide de premiers coefficients complexes de pondération, et l'onde reçue étant obtenue en pondérant des signaux reçus par les mêmes antennes (121) à l'aide de seconds coefficients complexes de pondération ;

- en présence dudit objet dans l'enceinte, on mesure (320) un second ensemble de valeurs complexes ($\mu_p$, $p = 1,...,2N$), chaque valeur complexe étant déterminée comme le rapport entre l'amplitude d'une onde reçue et une onde émise, l'onde émise étant obtenue en pondérant des signaux émis par les différentes antennes (121) à l'aide desdits premiers coefficients complexes de pondération, et l'onde reçue étant obtenue en pondérant des signaux reçus par les mêmes antennes (121) à l'aide desdits seconds coefficients complexes de pondération, et pour chaque valeur complexe du premier ou du second ensemble, les premiers coefficients de pondération sont les éléments d'un vecteur propre ($V_p$) d'une matrice de paramètres S corrigés et les seconds coefficients de pondération sont obtenus par conjugaison complexe des premiers coefficients de pondération, la matrice de paramètres S corrigés étant obtenue par différence entre la matrice de paramètres S d'un premier système et celle d'un second système, le premier système étant constitué de l'enceinte (110) et dudit réseau d'antennes (120), le second système étant constitué de l'enceinte (110), de l'objet (O) et dudit réseau d'antennes (121), les paramètres S du premier et du second systèmes étant mesurés pour chaque antenne d'émission (121) ainsi que chaque polarisation d'émission (H ; V) et chaque antenne de réception (121) ainsi que chaque polarisation de réception (H ; V);

- on soustrait (330) les valeurs complexes du premier ensemble $(\mu_p^0,\ p=1,...,2N)$ aux valeurs complexes correspondantes du second ensemble ($\mu_p$, $p$=1,...,2$N$) pour obtenir une liste de valeurs complexes corrigées $(\lambda_p = \mu_p - \mu_p^0)$ et on fournit au moins une sous- liste de la liste de valeurs complexes corrigées comme caractéristique électromagnétique dudit objet (O).

2. Méthode de caractérisation électromagnétique selon la revendication 1, **caractérisée en ce que** lesdits vecteurs propres ($V_p$) sont préalablement déterminés à partir d'une matrice des paramètres S corrigés, ladite matrice étant obtenue au moyen d'une simulation.

3. Méthode de caractérisation électromagnétique selon la revendication 1, **caractérisée en ce que** lesdits vecteurs propres (Vp) sont préalablement déterminés à partir d'une matrice des paramètres S corrigés, ladite matrice étant obtenue en utilisant une maquette dudit objet (O).

4. Méthode de caractérisation électromagnétique selon l'une des revendications précédentes, **caractérisée en ce que** l'enceinte (110) est de forme parallépipédique et ouverte à l'une de ses extrémités (112), le réseau d'antennes (120) étant disposé sur la face (111) du parallépipède opposée à l'extrémité ouverte (112).

5. Méthode de caractérisation électromagnétique selon l'une des revendications précédentes, **caractérisée en ce que** les parois de l'enceinte (110) sont métalliques.

6. Méthode de caractérisation électromagnétique selon l'une des revendications précédentes, **caractérisée en ce que** le réseau d'antennes (120) est bidimensionnel.

7. Méthode de caractérisation électromagnétique selon l'une des revendications précédentes, **caractérisée en ce qu'**elle est répétée pour une pluralité de fréquences appartenant à une bande de fréquence prédéterminée.

**Patentansprüche**

1. Verfahren zur elektromagnetischen Charakterisierung eines Objektes (O) mit einer gegebenen Frequenz, in dessen Verlauf man das Objekt (O) in einem Gehäuse (110) piatziert, von dem wenigstens einige Wände bei der Frequenz schwach absorbierend sind, wobei eine der Wände (111) des Gehäuses mit einem Antennennetz (120) ausgestattet ist, wobei jede Antenne (121) bei einer ersten Polarisation (H; V) sowie bei einer zur ersten Polarisation orthogonalen zweiten Polarisation (V; H) eine elektromagnetische Welle aussenden und elektromagnetische Wellen empfangen kann, wobei das Verfahren ferner die folgenden Schritte umfasst:

- in Abwesenheit des Objektes in dem Gehäuse misst man (310) eine erste Gruppe von komplexen Werten $(\mu_p^0,\ p=1,\ldots,2N)$, wobei jeder komplexe Wert bestimmt ist als das Verhältnis zwischen der Amplitude einer empfangenen Welle und einer ausgesandten Welle, wobei die ausgesandte Welle erhalten wird durch Gewichten von Signalen, die durch die verschiedenen Antennen (121) ausgesandt wurden, mittels erster komplexer Gewichtungskoeffizienten, und wobei die empfangene Welle erhalten wird durch Gewichten von Signalen, die durch die gleichen Antennen (121) empfangen wurden, mit Hilfe zweiter komplexer Gewichtungskoeffizienten;

- in Anwesenheit des Objektes in dem Gehäuse misst man (320) eine zweite Gruppe von komplexen Werten ($\mu_p$, p=1,...,2N), wobei jeder komplexe Wert bestimmt wird als das Verhältnis zwischen der Amplitude einer empfangenen Welle und einer ausgesandten Welle, wobei die ausgesandte Welle erhalten wird durch Gewichten von Signalen, die durch die verschiedenen Antennen (121) ausgesandt wurden, mit Hilfe der ersten komplexen Gewichtungskoeffizienten, und wobei die empfangene Welle erhalten wird durch Gewichten von Signalen, die durch die gleichen Antennen (121) empfangen wurden, mit Hilfe der zweiten komplexen Gewichtungskoeffizienten, und wobei für jeden komplexen Wert der ersten oder der zweiten Gruppe die ersten Gewichtungskoeffizienten die Elemente eines Eigenvektors ($V_p$) einer Matrix aus korrigierten Parametern S sind; und die zweiten Gewichtungskoeffizienten erhalten werden durch komplexe Konjugierung der ersten Gewichtungskoeffizienten, wobei die Matrix aus korrigierten Parametern S erhalten wird durch die Differenz zwischen der Matrix von Parametern S eines ersten Systems und jener eines zweiten Systems, wobei das erste System gebildet ist durch das Gehäuse (110) und das Antennennetz (120), wobei das zweite System gebildet ist durch das Gehäuse (110), das Objekt (O) und das Antennennetz (121), wobei die Parameter S des ersten und des zweiten Systems gemessen werden für jede Sendeantenne (121) sowie für jede Sendepolarisation (H; V) und für jede Empfangsantenne (121) sowie für jede Empfangspolarisation (H; V);

- man subtrahiert (330) die komplexen Werte der ersten Gruppe $\left(\mu_p^0,\ \ p=1,\ldots,2N\right)$ von den entsprechenden komplexen Werten der zweiten Gruppe ($\mu_p$, p=1,...,2N) um eine Leiste von korrigierten komplexen Werten $\left(\lambda_p=\mu_p-\mu_p^0\right)$ zu erhalten, und man liefert wenigstens eine Unterliste der Liste von korrigierten komplexen Werten als elektromagnetische Eigenschaft des Objektes (O).

2. Verfahren zur elektromagnetischen Charakterisierung nach Anspruch 1, **dadurch gekennzeichnet, dass** die Eigenvektoren ($V_p$) vorher bestimmt werden ausgehend von einer Matrix von korrigierten Parametern S, wobei die Matrix mittels einer Simulation erhalten wird.

3. Verfahren zur elektromagnetischen Charakterisierung nach Anspruch 1, **dadurch gekennzeichnet, dass** die Eigenvektoren ($V_p$) vorher bestimmt werden ausgehend von einer Matrix von korrigierten Parametern S, wobei die Matrix unter Verwendung eines Modells des Objektes (O) erhalten wird.

4. Verfahren zur elektromagnetischen Charakterisierung nach einem der vorhergehenden Ansprüche, **dadurch gekennzeichnet, dass** das Gehäuse (110) eine Parallelepipedform aufweist und an einem seiner Enden (112) offen ist, wobei das Antennennetz (120) an der Seite (111) des Parallelepipeds angeordnet ist, die dem offenen Ende (112) gegenüber liegt.

5. Verfahren zur elektromagnetischen Charakterisierung nach einem der vorhergehenden Ansprüche, **dadurch gekennzeichnet, dass** die Wände des Gehäuses (110) metallisch sind.

6. Verfahren zur elektromagnetischen Charakterisierung nach einem der vorhergehenden Ansprüche, **dadurch gekennzeichnet, dass** das Antennennetz (120) zweidimensional ist.

7. Verfahren zur elektromagnetischen Charakterisierung nach einem der vorhergehenden Ansprüche, **dadurch gekennzeichnet, dass** es für eine Mehrzahl von Frequenzen wiederholt wird, die zu einem vorbestimmten Frequenzband gehören.

**Claims**

1. A method for electromagnetically characterizing an object (0) at a given frequency, according to which said object (0) is placed in a chamber (110) whereof at least some of the walls have a low absorbance at said frequency, one of the chamber walls being equipped with an antenna array (120), each antenna (121) being able to transmit one and receive several electromagnetic waves according to a first polarization (V;H) and a second polarization orthogonal to the first, said method further comprising the following steps:

- when said object is not present in the chamber, a first set of complex values ( $\mu_p^0$ , $p = 1,...,2N$ ) is measured (310), each complex value being determined as the ratio between the amplitude of a received wave and a transmitted wave, the transmitted wave being obtained by weighting signals transmitted by the different antennas (121) using the first complex weighting coefficients, and the received wave being obtained by weighting signals received by the same antennas (121) using second complex weighting coefficients;

- when said object is present in the chamber, a second set of complex values ($\mu_p$, $p=1,...,2N$) is measured (320), each complex value being determined as the ratio between the amplitude of a received wave and a transmitted wave, the transmitted wave being obtained by weighting the signals transmitted by the different antennas (121) using said first complex weighting coefficients, and the received wave being obtained by weighting signals received by the same antennas (121) using said second complex weighting coefficients, and for each complex value of the first or second set, the first weighting coefficients are the elements of an eigenvector ($V_p$) of a matrix of corrected parameters S and the second weighting coefficients are obtained by complex conjugation of the first weighting coefficients, the matrix of corrected parameters S being obtained by the difference between the matrix of parameters S of a first system and that of a second system, the first system consisting of the chamber (110) and said antenna array (120), the second system consisting of the chamber (110), the object (0) and said antenna array (121), the parameters S of the first and second systems being measured for each transmitting antenna (121) as well as each transmission polarization (H;V) and each receiving antenna (121) as well as each receiving polarization (H;V);

- the complex values of the first set ( $\mu_p^0$ , $p = 1,...,2N$ ) are subtracted (330) from the corresponding complex values of the second set ($\mu_p$, $p=1,...,2N$) to obtain a list of corrected complex values ( $\lambda_p = \mu_p - \mu_p^0$ ) and at least one sublist of the list of corrected complex values is provided as electromagnetic characteristic of said object (0).

2. The electromagnetic characterization method according to claim 1, **characterized in that** said eigenvectors ($V_p$) are determined beforehand from a matrix of the corrected parameters S, said matrix being obtained using a simulation.

3. The electromagnetic characterization method according to claim 1, **characterized in that** said eigenvectors ($V_p$) can be determined beforehand from a matrix of corrected parameters S, said matrix being obtained by using a model of said object (0).

4. The electromagnetic characterization method according to one of the preceding claims, **characterized in that** the chamber (110) is parallelepiped and open at one end (112), the antenna array (120) being arranged on the face (111) of the parallelepiped opposite the open end (112).

5. The electromagnetic characterization method according to one of the preceding claims, **characterized in that** the walls of the chamber (110) are metallic.

6. The electromagnetic characterization method according to one of the preceding claims, **characterized in that** the antenna array (120) is two-dimensional.

7. The electromagnetic characterization method according to one of the preceding claims, **characterized in that** it is repeated for a plurality of frequencies belonging to a predetermined frequency band.

**Fig.1**

mesures des paramètres S
en absence de  O
$\rightarrow$ matrice  $S_0$

210

mesures des paramètres S
en présence de  O
$\rightarrow$ matrice  S

220

calcul de
$\Delta S = S - S_0$

230

Diagonalisation de
$\Delta S$

240

Caractérisation par liste ou
sous-liste
des valeurs propres

250

**Fig. 2**

Fig. 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2914750

**Littérature non-brevet citée dans la description**

- **R.F. HARRINGTON ; J.R. MAUTZ.** Theory of caracteristic modes for conducting bodies. *IEEE Trans. on Antennas and Propagation,* 1971, vol. AP-19 (5